# EUROPÄISCHE PATENTSCHRIFT

(11) **EP 2 491 095 B1**
(45) Veröffentlichungstag und Bekanntmachung des Hinweises auf die Patenterteilung: **07.01.2015**
(21) Anmeldenummer: 10785032.3
(22) Anmeldetag: 24.11.2010
(51) Int. Cl.: C09K 11/64, C09K 11/80, H01L 33/50

(54) **LEUCHTSTOFF UND LICHTQUELLE MIT DERARTIGEM LEUCHTSTOFF**
LUMINOPHORE AND LIGHT SOURCE CONTAINING SUCH A LUMINOPHORE
MATÉRIAU LUMINESCENT ET SOURCE DE LUMIÈRE COMPORTANT UN TEL MATÉRIAU LUMINESCENT

(30) Priorität: 22.12.2009 DE 102009055185
(43) Veröffentlichungstag der Anmeldung: 29.08.2012
(73) Patentinhaber: OSRAM GmbH, 80807 München (DE)
(72) Erfinder: FIEDLER, Tim, 81369 München (DE); JERMANN, Frank, 86343 Königsbrunn (DE); STRAUSS, Jörg, 86179 Augsburg (DE)
(74) Vertreter: Epping - Hermann - Fischer
(86) Internationale Anmeldenummer: PCT/EP2010/068102
(87) Internationale Veröffentlichungsnummer: WO 2011/085849

(56) Entgegenhaltungen:
- EP-A1- 0 155 047
- WO-A1-2008/015207
- WO-A1-2011/020756
- US-A1- 2009 152 575

## Beschreibung

### Technisches Gebiet

Die Erfindung geht aus von einem Leuchtstoff gemäß dem Oberbegriff des Anspruchs 1 und einer mit derartigem Leuchtstoff ausgestatteten Lichtquelle gemäß Anspruch 8, insbesondere einer Konversions-LED. Derartige Konversions-LEDs sind insbesondere für Allgemeinbeleuchtung geeignet.

### Stand der Technik

Aus der EP 1 696 016 ist eine Konversions-LED bekannt, die als roten Leuchtstoff ein Calsin verwendet. Mit dem Begriff Calsin ist ein CaAlSiN-Nitrid gemeint. Ein weiteres Calsin ist aus der WO 2008/015207 bekannt.

### Darstellung der Erfindung

Die Aufgabe der vorliegenden Erfindung ist es, einen Leuchtstoff gemäß dem Oberbegriff des Anspruchs 1 bereitzustellen, der es gestattet, die Eigenschaften von nitridischen Leuchtstoffen gezielt an spezielle Aufgaben anzupassen.

Diese Aufgabe wird gelöst durch die kennzeichnenden Merkmale des Anspruchs 1.

Besonders vorteilhafte Ausgestaltungen finden sich in den abhängigen Ansprüchen.

Erfindungsgemäß wird jetzt ein neuartiger nitridischer oder oxinitridischer Leuchtstoff bereitgestellt, beispielsweise ein Calsin oder Nitridosilikat M2Si5N8:Eu. Viele derartige Leuchtstoffe, insbesondere Nitride des Typs M2Si5N8:D mit D als Aktivator, erleiden beim Betrieb in einer LED deutliche Konversionsverluste. In kurzer Zeit (typisch 1000 Std.) verlieren derartige LEDs bis zu 50% Konversionseffizienz. Dies führt zu einer ausgeprägten Instabilität des Farborts. Weiße LEDs gewinnen in der Allgemeinbeleuchtung immer mehr an Bedeutung. Insbesondere steigt die Nachfrage nach warmweißen LEDs mit niedrigen Farbtemperaturen und guter Farbwiedergabe und gleichzeitig hoher Effizienz. Vor dem Hintergrund des kommenden Verbots der wenig energieeffizienten Allgebrauchsglühlampe gewinnen alternative Lichtquellen mit möglichst guter Farbwiedergabe (CRI) immer mehr an Bedeutung. Viele Verbraucher legen Wert auf Leuchtmittel mit glühlampenähnlichem Lichtspektrum.

Die Leuchtstoffe müssen eine Reihe von Anforderungen erfüllen: Eine sehr hohe Stabilität gegenüber chemischen Einflüssen, beispielsweise Sauerstoff, Feuchtigkeit, Wechselwirkungen mit Vergussmaterialien, sowie gegenüber Strahlung. Um einen stabilen Farbort bei steigender Systemtemperatur zu gewährleisten, sind außerdem Leuchtstoffe erforderlich, die ein sehr geringes Temperaturlöschverhalten aufweisen.

Die Erfindung basiert auf der Bereitstellung von Leuchtstoffen aus den Stoffklassen der Nitride bzw. Oxynitride mit verbesserten Eigenschaften durch das Einbringen von Kupfer-Ionen in das Kristallgitter. Cu wirkt hier nicht als Dotierung, sondern als Bestandteil des Wirtsgitters.

Derartige Cu-modifzierte Leuchtstoffe sind insbesondere Leuchtstoffe, die mit Eu allein oder in Verbindung mit anderen Aktivatoren dotiert sind, wie:
Nitridische Leuchstoffsyteme, wie M2-xCuxSi5N8:Eu mit M = (Sr,Ca,Ba), wobei der Grundtyp des Leuchtstoffs aus US 6 682 663 bekannt ist und
Ca1-xCuxAlSiN3:Eu, wobei der Grundtyp des Leuchtstoffs aus EP 1696016 bekannt ist sowie oxynitridischer Leuchstoffe, wie M1-xCuxSi2N2O2:Eu mit M = (Sr,Ca,Ba), wobei der Grundtyp des Leuchtstoffs aus WO 2004/030109 bekannt ist, sowie außerdem alpha-SiAlONe, wobei der Grundtyp des Leuchtstoffs aus US 6 657379 bekannt ist. Im Detail handelt es sich dabei um den Grundtyp, der der Formel M_{p/2}Si_{12-p-q}Al_{p+q}O_{q}N_{16-q}: Eu²⁺ gehorcht, mit M = Ca einzeln oder in Kombination mit Sr und Mg, mit q = 0 bis 2,5 und p = 0,5 bis 3. Bevorzugt wird ein hoher Wert für p gewählt, nämlich p = 2 bis 3, und ein relativ niedriger Wert für q, nämlich q = 0 bis 1. Statt reinem Al kann insbesondere eine Mischung Al, Ga mit bis zu 20 mol-% Anteil des Ga verwendet werden.

Dabei liegt im allgemeinen der Anteil des Eu bei 0,2 bis 15 Mol.-% des Kations M, insbesondere bei 0,5 bis 8 Mol.-%. Der Anteil des Cu am Wirtsgitter liegt bevorzugt bei 0,05 bis 5 Mol.-%.

Derartige Leuchtstoffe werden in weißen LEDs und Color-on-Demand LEDs eingesetzt. Eine Vielzahl von Patente beschreiben Variationen der Leuchstoffstöchiometrie, durch Einbringen von wirtsgitterfremden Ionen und die damit erzielten Änderungen der Eigenschaften.

Das Element Kupfer findet als Dotierelement in dem CRT-Leuchstoff Zinksulfid Anwendung. In WO2006/068360 wird Kupfer als Gitterbestandteil oxidischer Leuchtstoffsysteme genannt. Über das Einbringen von Kupfer in nitridischen bzw. oxynitridischen Leuchstoffen wurde bisher nicht berichtet. Bedingt durch die unterschiedlichen Eigenschaften, wie z.B. Ladung, Elektronegativität und Ionenradius, von Kupfer-Ionen im Vergleich zu Erdalkali-Ionen kann der Einbau von Cu-Ionen in das Kristallgitter von nitridischen bzw. oxynitridischen Leuchstoffen die Eigenschaften des Leuchtstoffs gezielt beeinflussen. So können Lage und/oder Form der Emissionsbande durch den Einbau von Kupfer und die dadurch veränderte Kristallfeldaufspaltung beeinflusst werden. Außerdem können sowohl die Effizienz, Absorptionseigenschaften als auch die Partikelmorphologie verändert werden. Als Ausführungsbeispiel kann hier die kurzwellige Verschiebung der Emission des Aktivators Europium in CaAlSiN3 durch den Einbau von Kupfer-Ionen in das Gitter angeführt werden.

Bevorzugt eignet sich Cu für den Einbau in CaAlSiN-Nitride, insbesondere in Ca(1-x)CuxAlSiN3:Eu2+, wobei der Anteil Cu, der Ca ersetzt bevorzugt in einem Bereich von 0,2 bis 5 Mol.-% liegt. Calcium kann dabei teilweise durch Sr und Ba, insbesondere bis zu einem Anteil von 30 Mol.-% ersetzt sein. Im Falle des Sr kann der Anteil bis zu 90 Mol.-% betragen. Die Anregung derartiger Leuchtstoffe geschieht bevorzugt mit kurzwelliger Strahlung im UV und kurzwelligen Blau, insbesondere im Bereich 360 bis 440 nm.

### Kurze Beschreibung der Zeichnungen

Im Folgenden soll die Erfindung anhand mehrerer Ausführungsbeispiele näher erläutert werden. Die Figuren zeigen:
- Fig. 1: eine Konversions-LED;
- Fig. 2: ein LED-Modul mit entfernt angebrachter Leuchtstoffmischung;
- Fig. 3: einen Vergleich der Emission von Leuchtstoffen des Typs Ca(1-x)CuxAlSiN3:Eu2+ (0.5%) ;
- Fig. 4: einen Vergleich der Helligkeit von Leuchtstoffen des Typs Ca(1-x)CuxAlSiN3:Eu2+(0.5%);
- Fig. 5: einen Vergleich der Änderung der Dominanzwellenlänge von Leuchtstoffen des Typs Ca(1-x)CuxAlSiN3:Eu2+(0.5%).
- Fig. 6: einen Vergleich der Änderung der relativen Helligkeit von Leuchtstoffen des Typs Ca(1-x)CuxAlSiN3:Eu2+(0.5%).
- Fig. 7: einen Vergleich der Änderung der Dominanzwellenlänge von Leuchtstoffen des Typs Ca(1-x)CuxAlSiN3:Eu2+(0.5%).
- Fig. 8: einen Vergleich der Emission von Leuchtstoffen des Typs Ca(1-x)CuxAlSiN3:Eu2+(0.5%).
- Figur 9: zeigt das Emissionsspektrum einer warmweißen LED auf Basis des neuartigen Leuchtstoffs im Vergleich zu einer bekannten warmweißen LED.

### Bevorzugte Ausführungsform der Erfindung

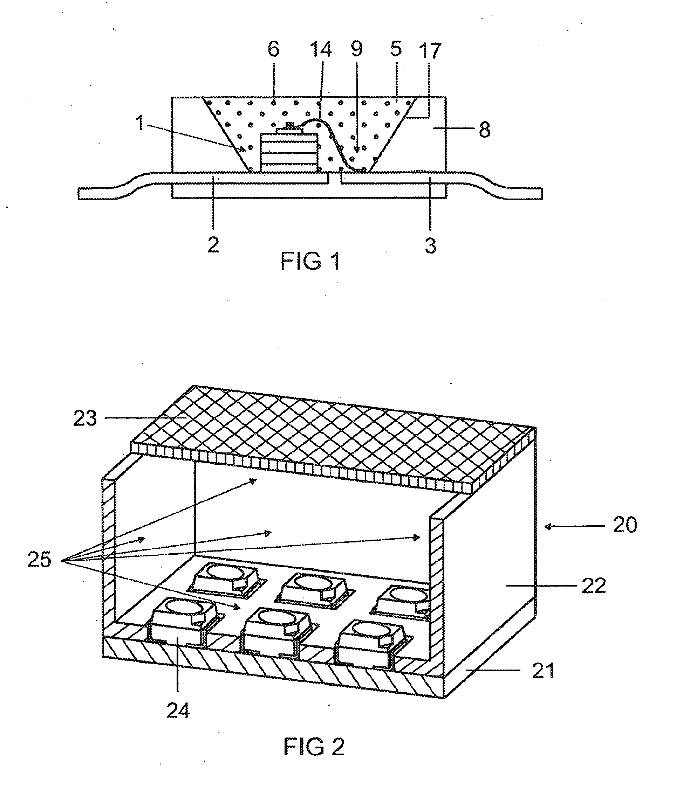

Figur 1 zeigt den Aufbau einer Konversions-LED für weißes Licht auf RGB-Basis wie an sich bekannt. Die Lichtquelle ist ein Halbleiterbauelement mit einem blau emittierende Chip 1 des Typs InGaN mit einer Peakemissionswellenlänge von 435 bis 455 nm Peakwellenlänge, beispielsweise 445 nm, das in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Silikon (60- 90 Gew.-%) und Leuchtstoffpigmente 6 (etwa 15 bis 40 Gew.-%) enthält. Ein erster Leuchtstoff ist ein grün emittierender Granat-Leuchtstoff Lu₃(Al,Ga)₅O₁₂:Ce (LuAGaG), sowie als zweiter Leuchtstoff ein rot emittierendes Alumonitridosilikat Ca0,99Cu0,01AlSiN3:Eu(0.5%). Die Ausnehmung hat eine Wand 17, die als Reflektor für die Primär- und Sekundärstrahlung vom Chip 1 bzw. den Pigmenten 6 dient.

Grundsätzlich ist die Verwendung der Leuchtstoff-Mischung als Dispersion, als Dünnfilm etc. direkt auf der LED oder auch, wie an sich bekannt, auf einem separaten, der LED vorgeschalteten Träger möglich. Figur 2 zeigt ein derartiges Modul 20 mit diversen LEDs 24 auf einer Grundplatte 21. Darüber ist ein Gehäuse montiert mit Seitenwänden 22 und einer Deckplatte 12. die Leuchtstoff-Mischung ist hier als Schicht 25 sowohl auf den Seitenwänden als auch vor allem auf der Deckplatte 23, die transparent ist, angebracht.

Andere geeignete Lichtquellen sind Leuchtstofflampen oder Hochdruckentladungslampen, bei denen der neuartige Leuchtstoff zur Konversion der primären Strahlung herangezogen werden kann, allein oder in Kombination mit anderen Leuchtstoffen.

Ein Beispiel eines modifizierten Leuchtstoffs vom grundsätzlichen Strukturtyp 'CaAlSiN3:Eu' ist Ca(1-x)CuxAlSiN3:Eu2+(0.5%).

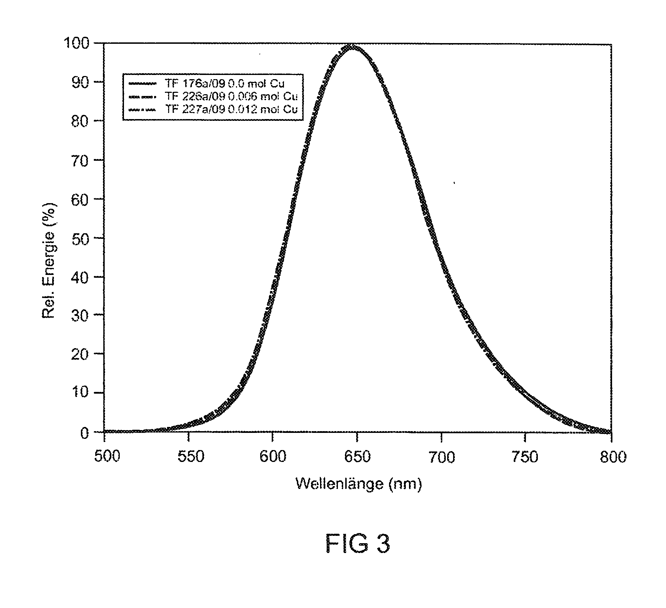

Figur 3 zeigt Emissionsspektren von Leuchtstoffen des Typs Ca(1-x)CuxAlSiN3:Eu2+(0.5%) in einer Cu-Konzentrationsreihe mit wechselndem x. Dabei liegt x in einem Bereich bis 0,012 mol.

Dabei zeigt sich, dass die Emission mit einem geringen Substitutionsgrad fast unverändert bleibt, mit höher Cu-Konzentration wird die Emission kurzwellig verschoben.

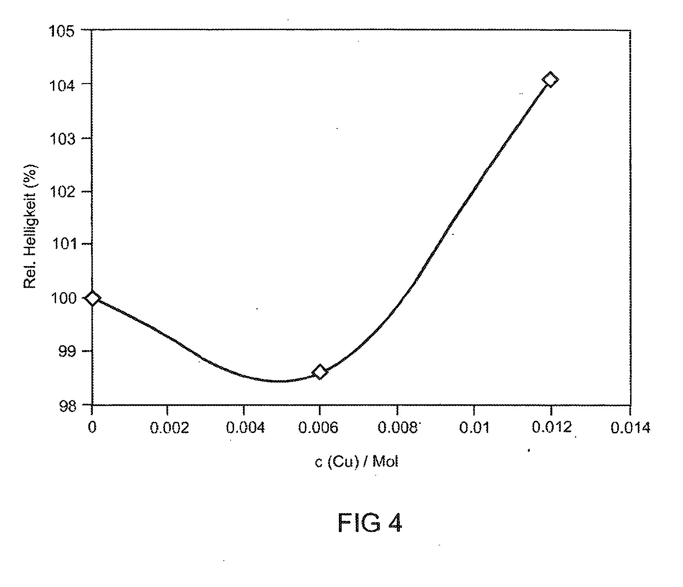

Figur 4 zeigt die Verbesserung der Helligkeit durch den Einbau von Cu-Ionen in das Calsin

Ca(1-x)CuxAlSiN3:Eu2+(0.5%) in einer Cu-Konzentrationsreihe mit wechselndem x.

Mit einem geringen Substitutionsgrad nimmt die Helligkeit ab. Sie nimmt überraschenderweise bei höheren Cu-Konzentrationen wieder zu.

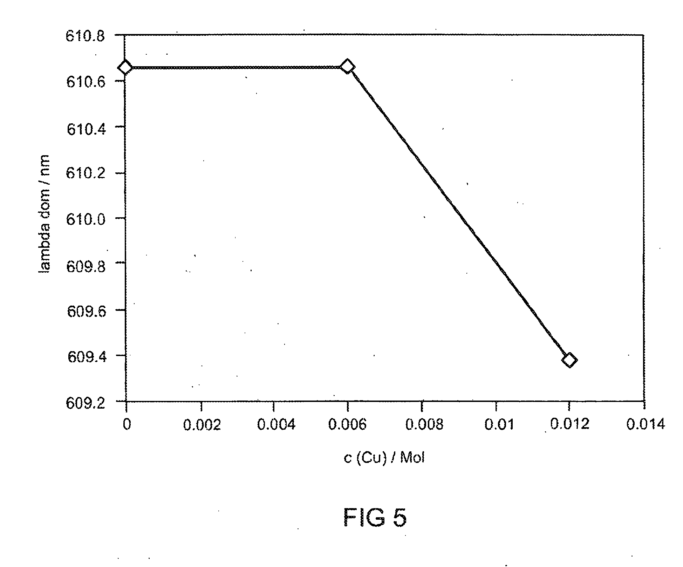

Figur 5 zeigt die Änderung der Dominanzwellenlänge durch Einbau von Kupfer in
Ca(1-x)CuxAlSiN3:Eu2+(0.5%).

Bei einem geringen Substitutionsgrad bleibt die Dominanzwellenlänge konstant. Sie verschiebt sich mit höherer Cu-Konzentration in die kurzwellige Richtung.

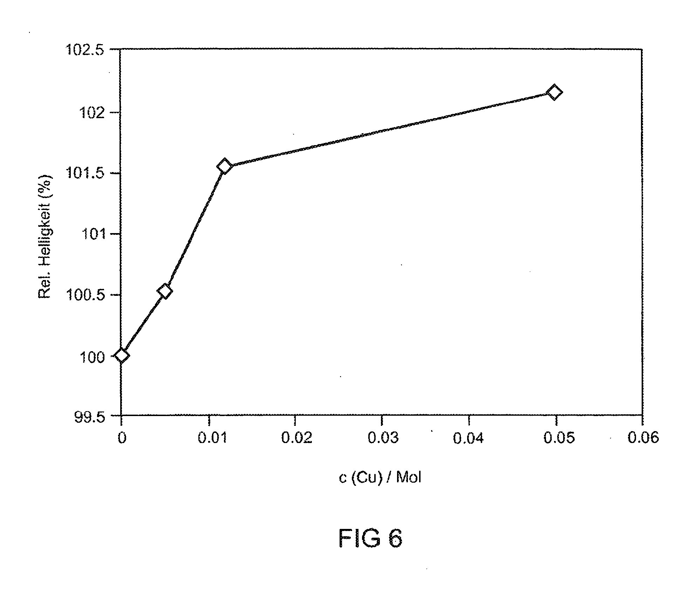

Figur 6 zeigt Verbesserung der Helligkeit durch Einbau von Kupfer in Ca(1-x)CuxAlSiN3:Eu2+(0.5%) unter Verwendung von Kupferfluorid (CuF2) als Precursor.

Mit zunehmendem Substitutionsgrad nimmt die Helligkeit zu. Das Maximum ist sehr breit und wird bei etwa 4 bis 10 Mol.-% erreicht, also 0,04 bis 0,1 mol.

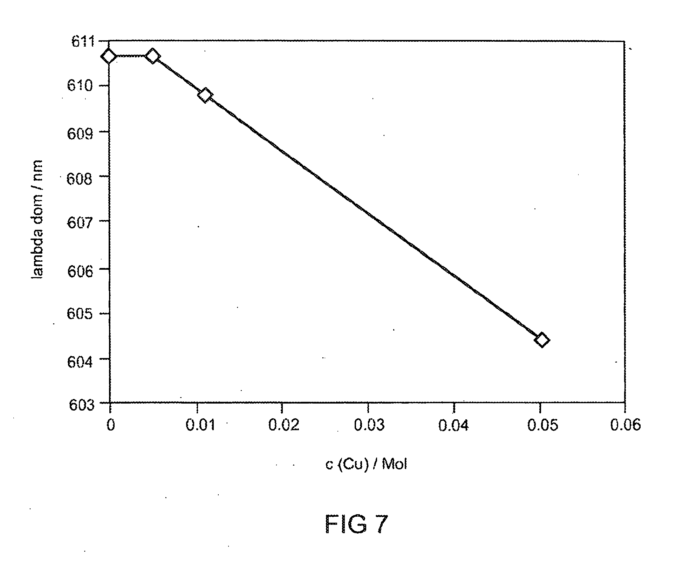

Figur 7 zeigt die Änderung der Dominanzwellenlänge durch Einbau von Kupfer in Ca(1-x)CuxAlSiN3:Eu2+(0.5%) unter Verwendung von Kupferfluorid (CuF2) als Precursor.

Bei einem geringen Substitutionsgrad bleib die Dominanzwellenlänge konstant und verschiebt sich mit höherer Cu-Konzentration linear kurzwellig, ähnlich wie bei Verwendung von Cu-Oxid.

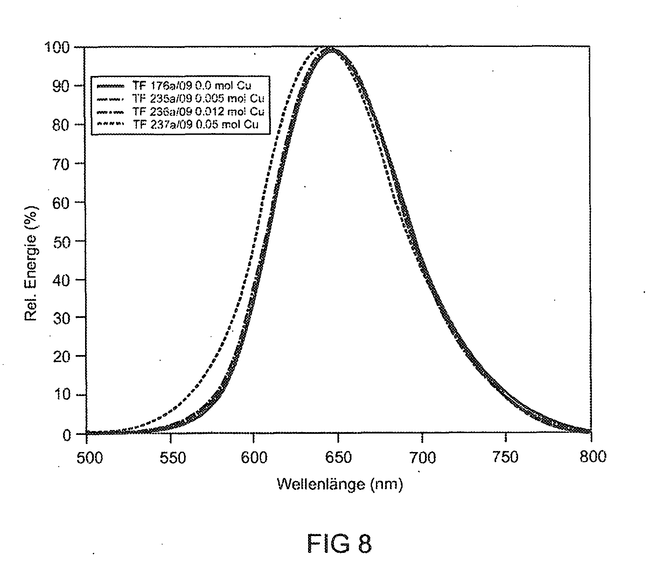

Figur 8 zeigt die Emissionsspektren von Leuchtstoffen Ca(1-x)CuxAlSiN3:Eu2+(0.5%) bei Verwendung von Kupferfluorid (CuF2) als Precursor.

Bei einem geringen Substitutionsgrad bleibt die Emission fast unverändert, mit höher Cu-Konzentration verschiebt sich das Emissionsmaximum kurzwellig.

Als Kupferquellen sind die Halogenide, Nitride und Oxide des Kupfers wie auch elementares Kupfer einsetzbär. Dabei werden bevorzugt die Halogenide, wie z. B. CuF2, CuCl2, eingesetzt, da diese Verbindungen reaktiv sind und den Vorteil besitzen, keinen Sauerstoff mit einzubringen, der die Eigenschaften des Leuchtstoffs negativ beeinflussen kann.

Kupfer-Ionen nehmen in einem (oxy-)nitridischen Wirtsgitter, wie auch in Kupfernitrid, bevorzugt die Oxidationszahl +1 an. Um eine ladungsneutrale Substitution zweiwertiger Erdalkali-Ionen durch einwertige Kupfer-Ionen zu erzielen, ist die Substitution einer gleichen Anzahl von Erdalkali-Ionen durch dreiwertiges Metall-Ionen, wie Ce, La, Pr, Y, Nd, Gd, Ho, Sm, Er, Lu, Dy, Tb, Tm, Yb, vorteilhaft. Zudem besteht z. B. im CaAlSiN- und alpha-SiAlON-System die Möglichkeit durch eine Anpassung des Aluminium/Silizium-Verhältnisses eine Ladungsneutralität zu erzielen. Der Ausgleich kann ebenfalls durch einen Stickstoff-Sauerstoff Austausch im Gitter erfolgen.

Für die Herstellung Cu-substituierter Leuchtstoffe sind bevorzugt Glühbehälter zu verwenden, die den Verlust gasförmiger Bestandteile wie beispielsweise durch Abdampfungen von Edukten minimieren. Die bei Synthesetemperatur leicht flüchtigen Kupfer-Verbindungen werden so in der Reaktionszone gehalten. Dadurch wird die Synthese weitgehend unabhängig vom Gasfluss im Ofen. Ein solcher Tiegel kann beispielsweise aus einem Rohr, gefertigt aus Molybdän oder Wolfram, und zwei einseitig geschlossenen Zylindern aus Aluminiumoxid, die von beiden Seiten dicht schließend auf das Rohr gesteckt werden, bestehen.

Bei einem konkreten Ausführungsbeispiel eines Leuchtstoffs Ca(1-x)CuxAlSiN3:Eu2+(0.5%) werden zunächst 10.219 g Calciumnitrid, 10.309 g Siliziumnitrid, 9.036g Aluminiumnitrid, 0.242 g Kupfer(II)fluorid und 0.194 g Europiumoxid eingewogen und homogenisiert. In einer Glovebox wird das Gemisch in lockerer Schüttung in ein aus Molybdän-Blech geformtes Rohr gefüllt und die beiden Enden mit jeweils einem einseitig geschlossenen Zylinder aus Aluminiumoxid dicht verschlossen. Die Glühung der Probe erfolgt in einem Rohrofen mit einem Arbeitsrohr aus Aluminiumoxid mit einen Durchmesser von 3 bis 6 cm. Das Rohr wird während der gesamten Temperung mit 0,5 bis 3 L/min Stickstoff gespült. Die Aufheizung erfolgt mit etwa 200 bis 500 K/min auf eine Plateautemperatur von 1550 bis 1680°C, die Haltezeit beträgt mehrere Stunden und die Abkühlung erfolgt ähnlich schnell wie die Aufheizung. Der abgekühlte Leuchtstoff wird in einer Mörsermühle gemahlen und über einer 54 µm Siebgaze gesiebt. Das Siebgut wird abermals in den dichten Tiegel gefüllt, nach demselben Temperaturprofil nochmals geglüht und anschließend gemahlen und gesiebt.

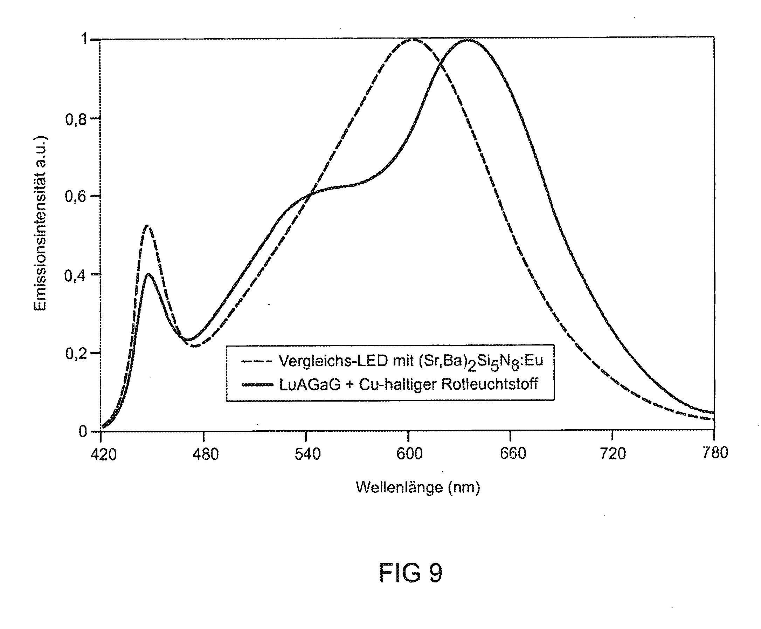

Figur 9 zeigt das Spektrum einer warmweißen LED auf Basis zweier Leuchtstoffe. Ein erster Leuchtstoff ist Lu3(Al,Ga)5O12:Ce, der zweite ist ein erfindungsgemäßer Leuchtstoff mit der Ansatzstöchiometrie:
(Cal-xCux)AlSiN3-2/3xF2x:Eu(0.5%) mit x = 0.012.

Diese Ansatzstöchiometrie entspricht nicht unbedingt und zwingend der Stöchiometrie der Verbindung, die bei der Glühung daraus entsteht.

Aus der Literatur ist die Verbindung LiSi2N3 bekannt und es konnte gezeigt werden, dass eine Verbindung Li1-2x-yCayEuxSi2-yAlyN3 existiert und gelblich leuchtet, siehe J. Solid State Chem. Vol. 182-2 (2009), S. 301-311. Die Lumineszenz ist jedoch sehr breitbandig und daher für die meisten Anwendungen nicht zu gebrauchen.

Die analoge Synthese der theoretisch denkbaren Verbindung CuSi2N3 ist jedoch bisher nicht gelungen. Überraschender Weise gelingt es jedoch mit einem neuartigen Ansatz (insbesondere Synthese über CuF2) hocheffiziente und schmalbandige Leuchtstoffverbindungen des Typs CuxCa1-xAl1-xSi1+xN3:Eu2+ (sowie auch andere Nitride und Oxynitride) darzustellen. Eine solche Verbindung mit einwertigem Cu, dessen Ladung beispielsweise durch eine Änderung des Al/Si-Verhältnisses ausgeglichen wird, ist bisher nicht bekannt. Bei kleinen x muss das Al/Si-Verhältnis nicht unbedingt angepasst werden, da überschüssiges Ca und Al - vermutlich in Form von Ca und AlF3 - abdampft.

Tab. 1 zeigt die Farbwiedergabe einer LED mit einer Leuchtstoffmischung aus Lu-Ga-Al-Granat und erfindungsgemäßem Rotleuchtstoff im Vergleich zu einer Mischung mit einem Rotleuchtstoff der Klasse (Sr,Ba)2Si5N8:Eu. Sowohl der Ra-Wert, der nur 8 Testfarben berücksichtigt, als auch der Ra14-Wert liegen deutlich über 90. Beim gesättigten Rot ist der Unterschied zum Stand der Technik besonders ausgeprägt.

**Tab. 1**

| LED-Typ | Blaue LED, Peak-Emission bei etwa 440 nm | Blaue LED, Peak-Emission bei etwa 440 nm |
|---|---|---|
| Erster Leuchtstoff | LuAGaG:Ce | LuAGaG:Ce |
| Zweiter Leuchtstoff | (Sr,Ba)2Si5N8:Eu | (Cal-xCux)AlSiN3-2/3xF2x:Eu(0.5%) mit x =0.012 |
| Ra(8) | 83 | 96 |
| Ra14 | 77 | 95 |
| R9 (gesättigtes Rot) | 12 | 92 |

Wesentliche Merkmale der Erfindung in Form einer numerierten Aufzählung sind:
1. Leuchtstoff aus der Klasse der nitridischen oder oxinitridischen Leuchtstoffe mit mindestens einem Kation M und einem Aktivator D, wobei ein Anteil x des Kations durch Cu ersetzt ist, wobei der Leuchtstoff aus der Gruppe folgender allgemeiner Strukturformeln ausgewählt ist: Ca₁₋ₓCuₓAlSiN₃: Eu, M₂₋ₓCuₓSi₅N₈: Eu mit M = (Sr, Ca, Ba), M₁₋ₓCuₓSi₂N₂O₂: Eu mit M = (Sr,Ca,Ba), wobei der Leuchtstoff mit Eu allein oder in Verbindung mit einem anderen Aktivator D, der mindestens ein Element aus der Reihe Ce, Sm, Yb und Tb ist, dotiert ist, wobei der Anteil x des Cu an M im Bereich 0,05 bis 5 Mol.-% liegt.
2. Leuchtstoff nach Vorschlag 1, wobei der Leuchtstoff die allgemeine Strukturformel M₂₋ₓCuₓSi₅N₈: Eu mit M = (Sr, Ca, Ba) oder M₁₋ₓCuₓSi₂N₂O₂: Eu mit M = (Sr, Ca, Ba) aufweist.
3. Leuchtstoff nach Vorschlag 1, wobei der Leuchtstoff Ca₁₋ₓCuₓAlSiN₃:Eu ist und der Anteil x in einem Bereich bis 1,2 mol-% liegt.
4. Leuchtstoff nach Vorschlag 1, dadurch gekennzeichnet, dass der Leuchtstoff Eu als Aktivator enthält.
5. Leuchtstoff nach Vorschlag 1, dadurch gekennzeichnet, dass der Anteil des Aktivators D im Bereich 0,2 bis 15 Mol.-% liegt.
6. Leuchtstoff nach Vorschlag 1, dadurch gekennzeichnet, dass der Anteil des Cu an M im Bereich 0,2 bis 5 Mol.-% liegt.
7. Lichtquelle mit einem Leuchtstoff nach einem der vorhergehenden Vorschläge.
8. Lichtquelle nach Vorschlag 1, dadurch gekennzeichnet, dass die Lichtquelle eine Konversions-LED, Leuchtstofflampe oder Hochdruckentladungslampe ist.
9. Konversions-LED mit einem Chip, der primäre Strahlung emittiert, sowie einer dem Chip vorgelagerten Leuchtstoff enthaltenden Schicht, die mindestens einen Teil der primären Strahlung des Chips in sekundäre Strahlung konvertiert, wobei zumindest ein erster Leuchtstoff gemäß einem der Vorschläge 1 bis 6 verwendet wird.
10.Konversions-LED nach Vorschlag 9, dadurch gekennzeichnet, dass als weiterer Leuchtstoff zur Erzeugung von Weiß (Lu,Y,Gd)₃(Al,Ga)₅O₁₂:Ce verwendet wird.
11.Konversions-LED nach Vorschlag 9, dadurch gekennzeichnet, dass der erste Leuchtstoff ein mit Cu modifiziertes CaAlSiN3:Eu ist.

## Patentansprüche

1. Leuchtstoff aus der Klasse der nitridischen oder oxinitridischen Leuchtstoffe mit mindestens einem Kation M und einem Aktivator D, wobei ein Anteil x des Kations durch Cu ersetzt ist, wobei der Leuchtstoff aus der Gruppe folgender allgemeiner Strukturformeln ausgewählt ist: Ca₁₋ₓCuₓAlSiN₃ : Eu, M₂₋ₓCuₓSi₅N₈:Eu mit M = (Sr, Ca, Ba) , M₁₋ₓCuₓSi₂N₂O₂: Eu mit M = (Sr, Ca, Ba), wobei der Leuchtstoff mit Eu allein oder in Verbindung mit einem anderen Aktivator D, der mindestens ein Element aus der Reihe Ce, Sm, Yb und Tb ist, dotiert ist, wobei der Anteil x des Cu an M im Bereich 0,05 bis 5 Mol.-% liegt.

2. Leuchtstoff nach Anspruch 1, wobei der Leuchtstoff die allgemeine Strukturformel M₂₋ₓCuₓSi₅N₈:Eu mit M = (Sr, Ca, Ba) oder M₁₋ₓCuₓSi₂N₂O₂ : Eu mit M = (Sr,Ca,Ba) aufweist.

3. Leuchtstoff nach Anspruch 1, **dadurch gekennzeichnet, dass** der Anteil des Cu an M in einem Bereich bis 1,2 mol-% liegt.

4. Leuchtstoff nach Anspruch 1, **dadurch gekennzeichnet, dass** der Leuchtstoff Eu als Aktivator enthält.

5. Leuchtstoff nach Anspruch 1, **dadurch gekennzeichnet, dass** der Anteil des Aktivators D im Bereich 0,2 bis 15 Mol.-% liegt.

6. Leuchtstoff nach Anspruch 1, **dadurch gekennzeichnet, dass** der Anteil des Cu an M im Bereich 0,2 bis 5 Mol.-% liegt.

7. Lichtquelle mit einem Leuchtstoff nach einem der vorhergehenden Ansprüche.

8. Lichtquelle nach Anspruch 1, **dadurch gekennzeichnet, dass** die Lichtquelle eine Konversions-LED, Leuchtstofflampe oder Hochdruckentladungslampe ist.

9. Konversions-LED mit einem Chip, der primäre Strahlung emittiert, sowie einer dem Chip vorgelagerten Leuchtstoff enthaltenden Schicht, die mindestens einen Teil der primären Strahlung des Chips in sekundäre Strahlung konvertiert, wobei zumindest ein erster Leuchtstoff gemäß einem der Ansprüche 1 bis 6 verwendet wird.

10. Konversions-LED nach Anspruch 9, **dadurch gekennzeichnet, dass** als weiterer Leuchtstoff zur Erzeugung von Weiß (Lu,Y,Gd)₃(Al,Ga)₅O₁₂:Ce verwendet wird.

11. Konversions-LED nach Anspruch 9, **dadurch gekennzeichnet, dass** der erste Leuchtstoff ein mit Cu modifiziertes CaAlSiN3:Eu ist.

## Claims

1. Phosphor from the class of nitridic or oxynitridic phosphors comprising at least one cation M and an activator D, wherein a proportion x of the cation is replaced by Cu, wherein the phosphor is selected from the group of the following general structural formulae: Ca₁₋ₓCuₓAlSiN₃:Eu, M₂₋ₓCuₓSi₅N₈:Eu where M = (Sr, Ca, Ba), M₁₋ₓCuₓSi₂N₂O₂ : Eu where M = (Sr,Ca,Ba), wherein the phosphor is doped with Eu alone or in conjunction with another activator D, which is at least one element from the series Ce, Sm, Yb and Tb, wherein the proportion x of the Cu in M is in the range of 0.05 to 5 mol%.

2. Phosphor according to Claim 1, wherein the phosphor has the general structural formula M₂₋ₓCuₓSi₅N₈:Eu where M = (Sr, Ca, Ba) or M₁₋ₓCuₓSi₂N₂O₂: Eu where M = (Sr, Ca, Ba).

3. Phosphor according to Claim 1, **characterized in that** the proportion of the Cu in M is in a range up to 1.2 mol%.

4. Phosphor according to Claim 1, **characterized in that** the phosphor contains Eu as activator.

5. Phosphor according to Claim 1, **characterized in that** the proportion of the activator D is in the range of 0.2 to 15 mol%.

6. Phosphor according to Claim 1, **characterized in that** the proportion of the Cu in M is in the range of 0.2 to 5 mol%.

7. Light source comprising a phosphor according to any of the preceding claims.

8. Light source according to Claim 1, **characterized in that** the light source is a conversion LED, fluorescent lamp or high-pressure discharge lamp.

9. Conversion LED comprising a chip, which emits primary radiation, and a phosphor-containing layer disposed in front of the chip, which layer converts at least part of the primary radiation of the chip into secondary radiation, wherein at least one first phosphor according to any of Claims 1 to 6 is used.

10. Conversion LED according to Claim 9, **characterized in that** (Lu,Y,Gd)₃(Al,Ga)₅O₁₂:Ce is used as further phosphor for generating white.

11. Conversion LED according to Claim 9, **characterized in that** the first phosphor is a Cu-modified CaAlSiN₃:Eu.

## Revendications

1. Substance luminescente choisie dans la classe des substances luminescentes de type nitrure ou oxynitrure comportant au moins un cation M et un activateur D, une partie x du cation étant remplacée par Cu, la substance luminescente étant choisie dans le groupe de formules structurales générales suivantes : Ca₁₋ₓCuₓAlSiN₃:Eu, M₂₋ₓCuₓSi₅N₈:Eu où M = (Sr, Ca, Ba), M₁₋ₓCuₓSi₂N₂O₂:Eu où M = (Sr, Ca, Ba), la substance luminescente étant dopée avec Eu seul ou conjointement avec un autre activateur D qui est au moins un élément choisi dans la série Ce, Sm, Yb et Tb, la proportion x du Cu de M se situant dans la plage de 0,05 à 5 % en moles.

2. Substance luminescente selon la revendication 1, la substance luminescente présentant la formule structurale générale M₂₋ₓCuₓSi₅N₈:Eu où M = (Sr, Ca, Ba) ou M₁₋ₓCuₓSi₂N₂O₂ : Eu où M = (Sr, Ca, Ba).

3. Substance luminescente selon la revendication 1, **caractérisée en ce que** la proportion du Cu de M se situe dans une plage allant jusqu'à 1,2 % en moles.

4. Substance luminescente selon la revendication 1, **caractérisée en ce que** la substance luminescente contient Eu comme activateur.

5. Substance luminescente selon la revendication 1, **caractérisée en ce que** la proportion de l'activateur D se situe dans la plage de 0,2 à 15 % en moles.

6. Substance luminescente selon la revendication 1, **caractérisée en ce que** la proportion du Cu de M se situe dans la plage de 0,2 à 5 % en moles.

7. Source lumineuse comportant une substance luminescente selon l'une quelconque des revendications précédentes.

8. Source lumineuse selon la revendication 1, **caractérisée en ce que** la source lumineuse est une LED de conversion, une tube fluorescent ou une lampe à décharge à haute pression.

9. LED de conversion comportant une puce, qui émet un rayonnement primaire, ainsi qu'une couche contenant une substance luminescente, placée devant la puce, qui convertit au moins une partie du rayonnement primaire de la puce en rayonnement secondaire, dans laquelle est utilisée au moins une première substance luminescente selon l'une quelconque des revendications 1 à 6.

10. LED de conversion selon la revendication 9, **caractérisée en ce qu'**on utilise comme autre substance luminescente pour la production de blanc (Lu,Y,Gd)₃(Al,Ga)₅O₁₂:Ce.

11. LED de conversion selon la revendication 9, **caractérisée en ce que** la première substance luminescente est un CaAlSiN₃:Eu modifié avec Cu.
